# EUROPÄISCHE PATENTSCHRIFT

(11) **EP 0 271 953 B1**
(45) Veröffentlichungstag und Bekanntmachung des Hinweises auf die Patenterteilung: **17.03.1993**
(21) Anmeldenummer: 87202463.3
(22) Anmeldetag: 09.12.1987
(51) Int. Cl.: H03G 1/00, H03F 3/45

(54) **Schaltungsanordnung mit steuerbarer Verstärkung**
Gain-controlled amplifier
Amplificateur à gain réglé

(30) Priorität: 13.12.1986 DE 3642620
(43) Veröffentlichungstag der Anmeldung: 22.06.1988
(73) Patentinhaber: Philips Patentverwaltung GmbH, 22335 Hamburg (DE); Philips Electronics N.V., 5621 BA Eindhoven (NL)
(72) Erfinder: Jansen, Winfrid, D-2081 Ellerbek (DE)
(74) Vertreter: Hartmann, Heinrich, Dipl.-Ing.

(56) Entgegenhaltungen:
- EP-A- 0 234 655
- DE-A- 3 027 071
- US-A- 3 812 434
- US-A- 3 909 738

## Beschreibung

Die Erfindung betrifft eine Verstärkerschaltung mit mindestens zwei ein- und ausgangsseitig miteinander gekoppelten Differenzverstärkern mit unterschiedlichen Verstärkungen, wobei zumindest die Verstärkung des Differenzverstärkers mit der höheren Verstärkung veränderbar ist.

Eine Verstärkerschaltung dieser Art, die beispielsweise zur Verstärkungsregelung in AM-Empfängern eingesetzt werden kann, ist aus der US-PS 3 909 738 bekannt. Die Differenzverstärker werden dabei durch emittergekoppelte Transistorpaare gebildet. Die Basis- und Kollektoranschlüsse des einen Paares, die den Eingang bzw. den Ausgang der Schaltung bilden, sind direkt mit den entsprechenden Anschlüssen des anderen Paares verbunden. Die unterschiedliche Verstärkung ergibt sich dadurch, daß bei dem einen Transistorpaar die Emitteranschlüsse direkt miteinander und mit einer Gleichstromquelle verbunden sind, während die Emitteranschlüsse des anderen Transistorpaares über gleich große Gegenkopplungswiderstände miteinander und der gemeinsamen Gleichstromquelle verbunden sind. Das letztgenannte Transistorpaar hat daher die niedrigere Verstärkung. Durch gegensinnige Änderung der den gemeinsamen Emitteranschlüssen der Transistorpaare zugeführten Gleichströme, kann die Verstärkung kontinuierlich zwischen dieser Verstärkung und der Verstärkung des anderen Transistorpaares variiert werden.

Die Aussteuerbarkeit im herabgeregelten Zustand - wenn also das Eingangssignal im wesentlichen nur durch den Verstärker mit den Emittergegenkopplungswiderständen verstärkt wird - ist dabei durch den Gleichspannungsabfall an den Gegenkopplungswiderständen in den Emitterzuleitungen gegeben. Die Aussteuerbarkeit könnte dabei zwar durch Vergrößerung dieser Widerstände erhöht werden, doch sind dem in der Praxis durch Anforderungen anderer Art Grenzen gesetzt.

Aufgabe der vorliegenden Erfindung ist es, die Aussteuerbarkeit einer Schaltung der eingangs genannten Art im herabgeregelten Zustand zu erhöhen.

Diese Aufgabe wird erfindungsgemäß dadurch gelöst, daß die Eingänge des Differenzverstärkers mit der niedrigeren Verstärkung über einen ersten Widerstand miteinander verbunden sind, und daß zwischen wenigstens einen Eingang dieses Differenzverstärkers und den entsprechenden Eingang des zweiten Differenzverstärkers ein zweiter Widerstand geschaltet ist.

Eine solche Schaltungsanordnung kann u.a. in einen Empfänger mit einem vorgeschalteten Filter eingesetzt werden, das durch einen ohmschen Widerstand abgeschlossen ist. Eine Weiterbildung der Erfindung sieht vor, daß der Widerstand als Spannungsteiler ausgebildet ist und daß der erste und zweite Widerstand Teile dieses Spannungsteilers sind. Dadurch wird erreicht, daß der erste bzw. der zweite Widerstand kein stärkeres Rauschen hervorrufen kann als der zum Abschluß des Filters ohnehin erforderliche Widerstand.

Auch wenn die Ansteuerung der Schaltungsanordnung unsymmetrisch erfolgt (d.h. nur der eine Eingang der Differenzverstärker mit der Signalquelle gekoppelt ist, während der andere Eingang an ein konstantes Potential angeschlossen ist), ist es zweckmäßig, wenn nach einer anderen Weiterbildung der Erfindung die Differenzverstärker symmetrisch ausgebildet sind.

Bei der Erfindung wird die Verstärkung des Differenzverstärkers mit der niedrigeren Verstärkung dadurch herabgesetzt, daß die Eingangsspannung auf den ersten Widerstand und den zweiten Widerstand bzw. die Widerstände zwischen den Eingängen des einen Differenzverstärkers und die entsprechenden Eingänge des anderen Differenzverstärkers aufgeteilt wird, wobei die Herabsetzung der Verstärkung von dem dadurch erzielten Spannungsteilungsfaktor abhängt. Die Verstärkung (im herabgeregelten Zustand) läßt sich jedoch noch weiter dadurch herabsetzen, daß nach einer Weiterbildung der Erfindung in die Emitterzuleitungen der Transistoren des Differenzverstärkers mit der niedrigeren Verstärkung Gegenkopplungswiderstände aufgenommen sind.

Die Erfindung wird nachstehend anhand der Zeichnung näher erläutert. Es zeigen:
- Fig. 1: ein Blockschaltbild eines AM-Empfängers, in dem die Erfindung anwendbar ist,
- Fig. 2: das Schaltbild eines bekannten Verstärkers mit regelbarer Verstärkung, und
- Fig. 3: das Schaltbild eines Verstärkers nach der Erfindung.

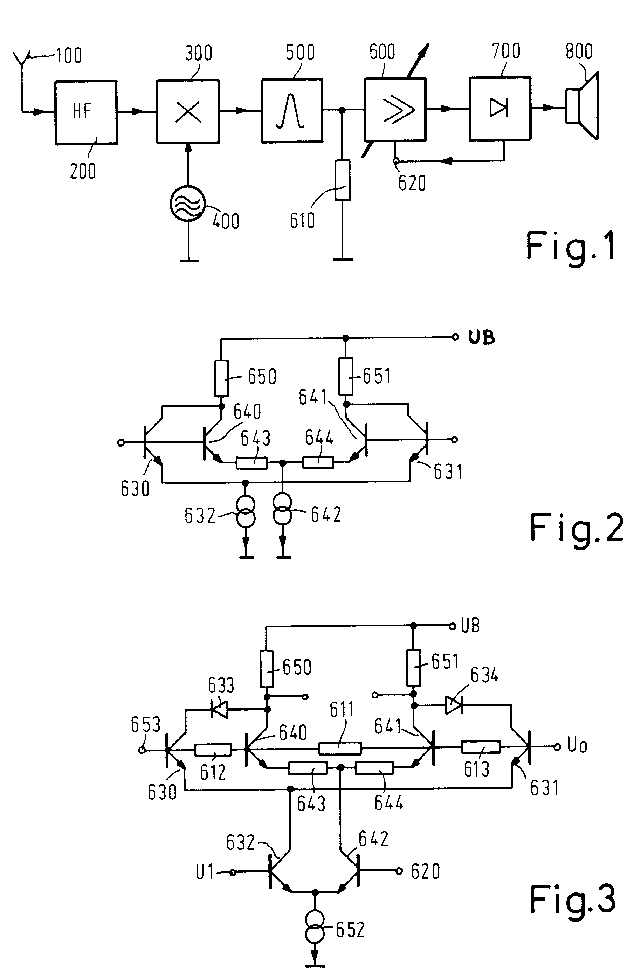

Das in Fig. 1 dargestellte Blockschaltbild eines AM-Rundfunkempfängers zeigt eine Antenne 100, deren Eingangssignal einer Hochfrequenz-Eingangsstufe 200 zugeführt wird, deren Ausgang mit dem Eingang einer Mischstufe 300 verbunden ist, in der das verstärkte und gefilterte Hochfrequenzeingangssignal mit dem von einem Oszillator 400 erzeugten Signal gemischt wird. Ein vorzugsweise mit Quarz- oder Keramikschwingern bestücktes, mit einem Abschlußwiderstand 610 abgeschlossenes Filter 500 filtert die bei dem Mischprozeß entstehenden Zwischenfrequenzschwingungen aus und führt sie einem Verstärker 600 zu, dessen Verstärkung durch eine Steuergleichspannung an seinem Steuereingang 620 veränderbar ist. Das verstärkte Zwischenfrequenzsignal wird einer Demodulator- und Niederfrequenz-Verstärkereinheit 700 zugeführt, die ein Audiosignal für einen Lautsprecher 800 und eine Regelgleichspannung erzeugt, die zum Zwecke der automatischen Verstärkungsregelung dem Steuereingang 620 zugeführt wird.

Fig. 2 zeigt das Prinzipschaltbild eines bekannten, als Zwischenfrequenzverstärker 600 einsetzbaren Verstärkers. Dieser umfaßt ein erstes Paar von Transistoren 630 und 631, deren Emitteranschlüsse direkt miteinander und mit einer gemeinsamen steuerbaren Gleichstromquelle 632 verbunden sind, und ein zweites Paar von Transistoren 640 und 641, deren Emitteranschlüsse miteinander und mit einer gemeinsamen Gleichstromquelle 642 über zwei Widerstände 643 und 644 verbunden sind. Die Basis- und die Kollektoranschlüsse der Transistoren 630 und 640 sind miteinander verbunden und ebenso die entsprechenden Anschlüsse der Transistoren 631 und 641. Das Eingangssignal wird entweder unsymmetrisch einem Eingang oder symmetrisch beiden Eingängen zugeführt, und das Ausgangssignal wird an einem oder beiden gemeinsamen Kollektoranschlüssen, die über je einen Widerstand 650 bzw. 651 an eine positive Versorgungsspannung UB angeschlossen sind, abgenommen.

Die Verstärkung wird durch gegensinnige Änderung der von den steuerbaren Gleichstromquellen 632 und 642 gelieferten Gleichströme erzeugt und ist somit zwischen einem durch die Verstärkung des Transistorpaares 630, 631 gegebenen Maximalwert und einem durch die Verstärkung des Transistorpaares 640, 641 gegebenen Minimalwert veränderbar. Im herabgeregelten Zustand, d.h. wenn die Signalverstärkung im wesentlichen durch das Transistorpaar 640, 641 bestimmt ist, ist die Aussteuerbarkeit, d.h. die größte im wesentlichen verzerrungsfrei verarbeitbare Differenz-Eingangsspannung,gegeben durch den Spannungsabfall, den der Gleichstrom der Quelle 642 an einem der beiden Widerstände 643 bzw. 644 hervorruft - falls keiner der Transistoren 640, 641 dabei in die Sättigung gerät.

Grundsätzlich könnte die Aussteuerbarkeit durch Vergrößerung der Widerstände 643, 644 vergrößert werden. Jedoch stehen einer solchen Vergrößerung in der Praxis meist andere Forderungen entgegen, beispielsweise die Forderung nach einer höheren Verstärkung.

In Fig. 3, in der für gleiche Teile dieselben Bezugszeichen verwendet sind wie in Fig. 2, ist ein erfindungsgemäßer Verstärker dargestellt, bei dem die Aussteuerbarkeit ohne Vergrößerung der Gegenkopplungswiderstände 643 und 644 erhöht ist. Diese Schaltung umfaßt ebenfalls ein erstes emittergekoppeltes Transistorpaar 630 und 631, das die maximale Verstärkung bestimmt, und ein zweites emittergekoppeltes Transistorpaar 640, 641, das die minimale Verstärkung bestimmt. Das Eingangssignal wird dem Transistorpaar 640, 641 jedoch über einen Spannungsteiler zugeführt, der einen Widerstand 611 zwischen den Basen der Transistoren 640 und 641 enthält sowie je einen Widerstand 612 bzw. 613 zwischen den Basen der mit der gleichen Eingangsklemme gekoppelten Transistoren 630, 640 bzw. 631, 641. Dadurch kann die Aussteuerbarkeit bis an die Betriebsspannung oder bei entsprechender Dimensionierung des Spannungsteilers auch darüber hinaus erhöht werden. Da der Spannungsteiler zugleich auch eine Verringerung der Verstärkung bewirkt, können die Emitterwiderstände 643 und 644 auch ganz entfallen. Von besonderem Vorteil ist es, wenn der Gesamtwiderstand des Spannungsteilers 611...613 dem Abschlußwiderstand des vorangehenden Filters entspricht, so daß dieser entfallen kann. In diesem Fall wird durch die Widerstände des Spannungsteilers kein zusätzliches Rauschen hervorgerufen.

Wenn die Schaltung, wie in dem Beispiel nach Fig. 1, unsymmetrisch betrieben wird, d.h. wenn das Eingangssignal lediglich der mit den Basen der Transistoren 630 und 640 gekoppelten Eingangsklemme 653 zugeführt wird, während die andere Eingangsklemme an ein konstantes Potential Uo angeschlossen ist - in diesem Fall kann der Widerstand 613, der die Basis des Transistors 641 mit dem konstanten Potential Uo auch entfallen - , dann genügt es, wenn der an ein konstantes Potential angeschlossene Eingang wechselspannungsmäßig mit Masse verbunden ist, beispielsweise durch einen nicht näher dargestellten Kondensator oder dadurch, daß der Innenwiderstand des die Vorspannung Uo erzeugenden Gleichspannungsgebers klein ist im Vergleich zum Gesamtwiderstand des Spannungsteilers 611...613.

Eine in Durchlaßrichtung zwischen den Kollektor des Transistors 640 und den Kollektor des Transistors 630 geschaltete Diode 633 verhindert, daß in stark herabgeregeltem Zustand bei einem großen Eingangssignal die Kollektorbasisdiode des Transistors 630 leitend wird und dadurch das Eingangssignal bzw. das Ausgangssignal an den Kollektorwiderständen 650, 651 verzerrt. Diese Gefahr ist bei unsymmetrischem Betrieb für die Basis-Kollektor-Diode des Transistors 631 geringer, doch ist es zweckmäßig, zur Herstellung der Symmetrie auch dessen Kollektor über eine in Durchlaßrichtung geschaltete Diode 634 mit dem Kollektor des Transistors 641 zu verbinden.

Zwei Transistoren 632 und 642, deren Emitter miteinander und mit einer Gleichstromquelle 652 verbunden sind und deren Kollektoren an die Verbindungspunkte der Emitter der Transistoren 630 und 631 bzw. der Widerstände 643 und 644 angeschlossen sind, dienen als Gleichstromquelle. Die Basis des Transistors 632 ist ein an ein konstantes Potential U1 (das niedriger ist als Uo) angeschlossen, während die Basis des Transistors 642 den Steuereingang bildet, dem eine mit wachsender Niederfrequenzamplitude positiver werdende Regelspannung zugeführt wird. Wenn die Regelspannung mit wachsender Amplitude negativer werden würde, müßten die Basisanschlüsse vertauscht werden. Die Gleichstromquellen 632 und 642 können auch auf andere Weise realisiert werden. Wesentlich ist nur, daß das Ausgangssignal zumindest des Differenzverstärkers (630, 631) mit der größeren Verstärkung elektronisch variiert werden kann.

Die Erfindung wurde vorstehend anhand eines Ausführungsbeispiels mit zwei ein- und ausgangsseitig miteinander gekoppelten Differenzverstärkern erläutert. Sie ist aber auch bei mehr als zwei Differenzverstärkern anwendbar; in diesen Fällen müßten ein bzw. mehrere Differenzverstärker entsprechende Spannungsteiler - jedoch mit anderem Spannungsteilerverhältnis - aufweisen.

## Patentansprüche

1. Verstärkerschaltung mit mindestens zwei ein- und ausgangsseitig miteinander gekoppelten Differenzverstärkern mit unterschiedlichen Verstärkungen, wobei zumindest die Verstärkung des Differenzverstärkers mit der höheren Verstärkung veränderbar ist,
dadurch gekennzeichnet, daß die Eingänge des Differenzverstärkers mit der niedrigeren Verstärkung über einen ersten Widerstand (611) miteinander verbunden sind, und daß zwischen wenigstens einen Eingang dieses Differenzverstärkers und den entsprechenden Eingang des zweiten Differenzverstärkers ein zweiter Widerstand (612) geschaltet ist.

2. Verstärkerschaltung nach Anspruch 1,
dadurch gekennzeichnet, daß der Schaltung ein Filter, vorgeschaltet ist, das durch einen ohmschen Widerstand (611...613) abgeschlossen ist, der als Spannungsteiler ausgebildet ist, und daß der erste und zweite Widerstand Teile dieses Spannungsteilers sind.

3. Verstärkerschaltung nach Anspruch 1 oder 2,
dadurch gekennzeichnet, daß die Differenzverstärker durch ein emittergekoppeltes Transistorpaare gebildet sind und die Verstärkung durch Änderung des dem ihrem Emitteranschluß zugeführten Gleichstromes veränderbar ist, und daß der Kollektor wenigstens eines der Transistoren (630, 631) des Differenzverstärkers mit der höheren Verstärkung über eine in Durchlaßrichtung geschaltete Diode (633, 634) mit dem einen Ausgangsanschluß der Schaltungsanordnung bildenden Kollektoranschluß des zugehörigen Transistors (640, 641) des anderen Transistorpaares verbunden ist.

4. Vestärkerschaltung nach einem der Ansprüche 1 bis 3,
gekennzeichnet durch eine symmetrische Ausbildung.

5. Verstärkerschaltung nach Anspruch 3,
dadurch gekennzeichnet, daß in die Emitterzuleitungen der Transistoren (640, 641) des Differenzverstärkers mit der niedrigeren Verstärkung Gegenkopplungswiderstände (643, 644) aufgenommen sind.

## Claims

1. Amplifier arrangement comprising at least two differential amplifiers having different gain factors and having their inputs coupled to each other and their outputs coupled to each other, whereas at least the gain of the differential amplifier that has the higher gain factor is variable, characterized in that the inputs of the differential amplifier that has the lower gain factor are connected to each other across a resistor (611) and in that a second resistor (612) is connected between at least one input of said differential amplifier and the corresponding input of the other differential amplifier.

2. Amplifier arrangement as claimed in Claim 1, characterized in that the arrangement is preceded by a filter which is terminated by an ohmic resistance (611 ..., 613) arranged as a voltage divider, and in that the first and second resistors form parts of this voltage divider.

3. Amplifier arrangement as claimed in Claim 1 or 2, characterized in that the differential amplifiers comprise each an emitter-coupled pair of transistors having a common emitter terminal and the gain of each differential amplifier can be varied by varying the direct current applied to their common emitter terminal, and in that the collector of at least one of the transistors (630, 631) of the differential amplifier that has the higher gain factor is connected to the collector terminal of the associated transistor (640, 641) of the other pair of transistors *via* a diode (633, 634) poled in forward direction.

4. Amplifier arrangement as claimed in one of the Claims 1 to 3, characterized by a symmetrical structure.

5. Amplifier arrangement as claimed in Claim 3, characterized in that negative-feedback resistors (643, 644) are included in the lines to the emitters of the transistors (640, 641) of the differential amplifier that has the lower gain factor.

## Revendications

1. Circuit amplificateur comportant au moins deux amplificateurs différentiels à amplifications différentes, qui sont connectés l'un à l'autre du côté de l'entrée et du côté de la sortie, au moins l'amplification de l'amplificateur différentiel dont l'amplification est la plus forte étant modifiable, caractérisé en ce que les entrées de l'amplificateur différentiel dont l'amplification est la plus faible sont connectées l'une à l'autre par l'intermédiaire d'une première résistance (611) et qu'entre au moins une entrée de cet amplificateur différentiel et l'entrée correspondante du second amplificateur différentiel est montée une seconde résistance (612).

2. Circuit amplificateur suivant la revendication 1, caractérisé en ce qu'il est précédé d'un filtre terminé par une résistance ohmique (611 à 613) qui a la forme d'un diviseur de tension et que la première et la seconde résistance font partie de ce diviseur de tension.

3. Circuit amplificateur suivant la revendication 1 ou 2, caractérisé en ce que les amplificateurs différentiels sont formés par des paires de transistors couplés par les émetteurs et l'amplification peut être modifiée par une variation du courant continu appliqué à leur connexion d'émetteur, et que le collecteur d'au moins l'un des transistors (630, 631) de l'amplificateur différentiel présentant l'amplification la plus forte est connecté, par l'intermédiaire d'une diode montée dans le sens passant (633, 634), à une connexion de collecteur du transistor associé (640, 641) de l'autre paire de transistors formant une connexion de sortie du montage de circuit.

4. Circuit amplificateur suivant l'une quelconque des revendications 1 à 3, caractérisé par une configuration symétrique.

5. Circuit amplificateur suivant la revendication 3, caractérisé en ce que des résistances de contreréaction (643, 644) sont incorporées dans les conducteurs d'alimentation d'émetteur des transistors (640, 641) de l'amplificateur différentiel présentant l'amplification la plus faible.
